# EUROPEAN PATENT APPLICATION

(11) **EP 0 612 189 A2**
(43) Date of publication of application: **24.08.1994**
(21) Application number: 94300543.9
(22) Date of filing: 25.01.1994
(51) Int. Cl.: H04N 9/45, H04N 9/64, H03K 5/00

(54) **A frequency multiplier**

(30) Priority: 15.02.1993 KR 932056
(71) Applicant: Samsung Electronics Co., Ltd., Suwon-city, Kyungki-do 441-370 (KR)
(72) Inventor: Chon, Byung-hoan, Mapo-gu, Seoul (KR); Min, Sung-ki, Buk-gu, Incheon-city (KR); Kwon, Sung-sub, Mapo-gu, Seoul (KR)
(74) Representative: Musker, David Charles

(57) **Abstract**

A frequency multiplier of a character generating circuit is disclosed, wherein two frequency doublers which include a phase inverter (30) for inverting a phase by inputting a color sub-carrier signal, a 90° phase shifter (40) for shifting a phase by 90° by inputting the color sub-carrier signal, and an analog multiplier (50) for outputting a doubled signal that multiplies the output of the phase inverter by the output of the 90° phase shifter, are connected in series so as to generate a clock to create a blue screen, to thereby reduce product cost and noise.

## Description

The present invention relates to a frequency multiplier, and more particularly to a frequency multiplier to be applied to a character generating circuit.

When a video signal cannot be input to an integrated circuit for character generation used in a television or a video tape recorder, a blue screen created in the integrated circuit is embodied using a color sub-carrier signal which is quadrupled externally. The color sub-carrier frequency is 3.58MHz in the case of NTSC systems, and is 4.43MHz for PAL systems.

In the conventional art, an externally provided quartz-crystal oscillator supplies an integrated circuit with a 4f_{sc} signal (the color sub-carrier frequency signal f_{sc} quadrupled), to create a clock in a character generating integrated circuit. Then, using an internal inverter, the character generating integrated circuit conditions the 4f_{sc}signal for use as a clock to generate the blue screen signal. However, if such an external quartz-crystal oscillator is utilized, the system becomes overly large and noise increases.

The object of the present invention is to provide a frequency multiplier that has a simple circuit construction.

It is another object of the present invention to provide a frequency multiplier which can reduce noise by generating a frequency multiplied signal inside an integrated circuit, without using a quartz-crystal oscillator.

To accomplish one or both of the above objects, there is provided a frequency multiplier circuit which generates a clock to create a blue screen by serially connecting two frequency doublers both of which comprise:
phase inverting means for receiving a color sub-carrier signal and inverting the phase of a signal;
90° phase shifting means for receiving the above color sub-carrier signal and shifting the phase by 90°; and
multiplying means for exclusive OR-multiplying the output signals of the phase inverting means and 90° phase shifting means and for outputting the multiplied signal. This is to say, the above clock generating circuit for the use of a blue screen is integrated within the character generating circuit.

Other aspects and embodiments of the invention are as recited in the claims.

The above objects and other advantages of the present invention will become more apparent by describing in detail a preferred embodiment thereof with reference to the attached drawings in which:
FIG.1 is a block diagram of a frequency multiplier of the present invention;
FIG.2 is a block diagram of a frequency doubler shown in FIG.1;
FIG.3 illustrates a detailed circuit of a frequency doubler shown in FIG.2; and
FIGs.4A-4E illustrate output waveforms at various points of the circuit shown in FIG.3.

A frequency multiplier of the present invention will be described below in more detail with reference to the attached drawings;

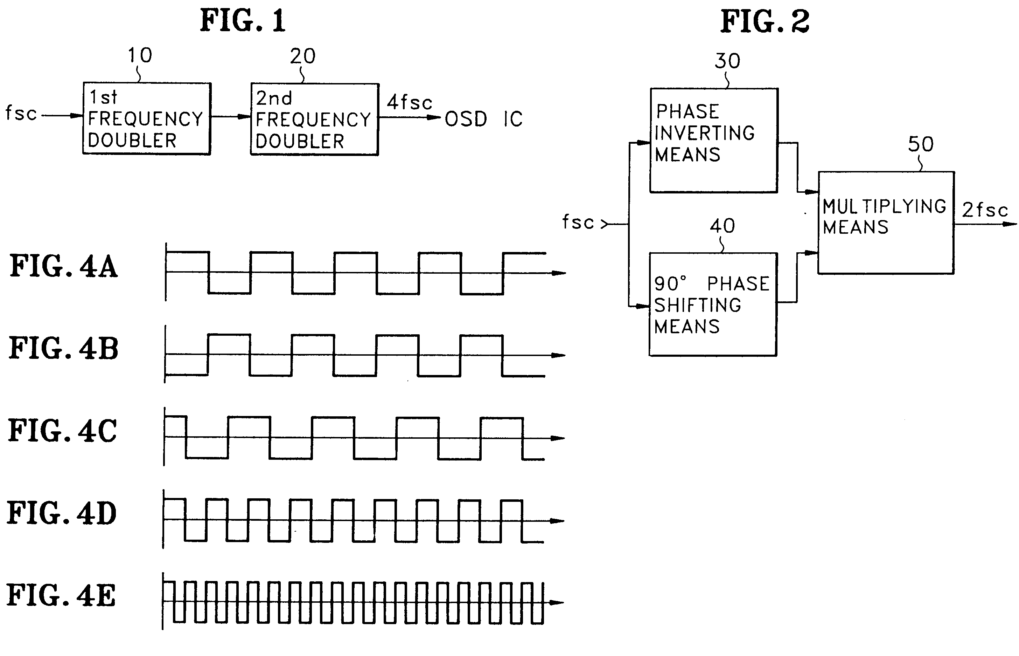

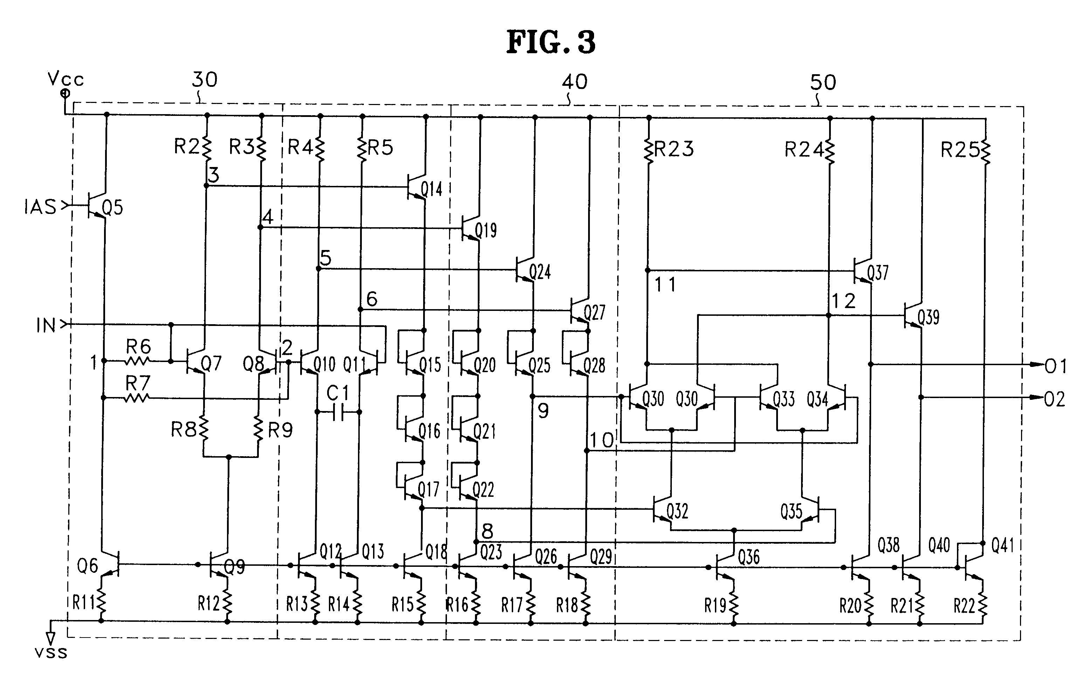

Referring to FIG.1, the frequency multiplier of the present invention includes a first frequency doubler 10 which inputs and doubles a color sub-carrier signal f_{sc}, and a second frequency doubler 20 which inputs and doubles the above doubled signal (2f_{sc}), and then outputs a quadrupled signal 4f_{sc}.

In other words, the present invention connects two frequency doublers in series, which results in a frequency quadrupler.

FIG.2 is a block diagram of a frequency doubler shown in FIG.1.

The frequency doubler shown in FIG.2 includes a phase inverting means 30 which inputs a color sub-carrier signal f_{sc} and inverts a phase, a 90° phase shifting means 40 which inputs the above color sub-carrier signal f_{sc} and shifts its phase by 90° and an analog multiplying means 50 which exclusive OR-multiplies the output signals of phase inverting means 30 and 90° phase shifting means, and then outputs a doubled signal.

FIG.3 shows a detailed circuit of a block diagram shown in FIG.2.

Referring to FIG.3, phase inverting means 30 comprises a transistor Q5 whose collector is connected to a power supply voltage V_{cc} and whose base is connected to a bias voltage (BIAS), a transistor Q6 whose collector is connected to the emitter of transistor Q5, a resistor R11 one end of which is connected to the emitter of transistor Q6 and the other of which is connected to ground (Vₛₛ), a resistor R2 one end of which is connected to the power supply voltage, a resistor R3 one end of which is connected to the power supply voltage, a resistor R6 one end of which is connected to the emitter of transistor Q5 and the other of which is connected to an input terminal (IN) for inputting a color sub-carrier signal f_{sc}, a resistor R7 one end of which is connected to the collector of transistor Q6, a transistor Q7 whose base is connected to the other end of resistor R6 and whose collector is connected to the other end of resistor R2, a transistor Q8 whose collector is connected to the other end of resistor R3 and whose base is connected to the other end of resistor R7, a resistor R8 one end of which is connected to the emitter of transistor Q7, a resistor R9 one end of which is connected to the emitter of transistor Q8 and the other end is connected to the other end of resistor R8, a transistor Q9 whose base is connected to the base of transistor Q6 and whose collector is connected to the other end of resistor R9, and a resistor R12 one end of which is connected to the emitter of transistor Q9 and the other end is connected to ground.

The above 90° phase shifting means 40 comprises a resistor R4 one end of which is connected to the power supply voltage, a transistor Q10 whose collector is connected to the other end of resistor R4 and whose base is connected to the base of transistor Q8 of phase inverting means 30, a transistor Q12 whose collector is connected to the emitter of transistor Q10 and whose base is connected to the base of transistor Q9 of phase inverting means 30, a resistor R13 one end of which is connected to the emitter of transistor Q12 and the other end of which is connected to ground, a resistor R5 one end of which is connected to the power supply voltage, a transistor Q11 whose collector is connected to the other end of resistor R5 and whose base is connected to the input terminal, a capacitor C1 one end of which is connected to the emitter of transistor Q11 and the other end of which is connected to the emitter of transistor Q10, a transistor Q13 whose collector is connected to the emitter of transistor Q11 and whose base is connected to the base of transistor Q12, a resistor R14 one end of which is connected to the emitter of transistor Q13 and the other end of which is connected to ground, a transistor Q14 whose collector is connected to the power supply voltage and whose base is connected to the other end of resistor R2 of phase inverting means 30, a transistor Q15 whose collector and base are both connected to the emitter of transistor Q14, a transistor Q16 whose collector and base are both connected to the emitter of transistor Q15, a transistor Q17 whose collector and base are both connected to the emitter of transistor Q16, a transistor Q18 whose collector is connected to the emitter of transistor Q17 and whose base is connected to the base of transistor Q13, a resistor R15 one end of which is connected to the emitter of transistor Q18 and the other of which is connected to ground, a transistor Q19 whose collector is connected to the power supply voltage and whose base is connected to the other end of resistor R3 of phase inverting means 30, a transistor Q20 whose collector and base are both connected to the emitter of transistor Q19, a transistor Q21 whose collector and base are both connected to the emitter of transistor Q20, a transistor Q22 whose collector and base are both connected to the emitter of transistor Q21, a transistor Q23 whose collector is connected to the emitter of transistor Q22 and whose base is connected to the base of transistor Q18, a resistor R16 one end of which is connected to the emitter of transistor Q23 and the other of which is connected to ground, a transistor Q24 which collector is connected to the power supply voltage and whose base is connected to the other end of resistor R4, a transistor Q25 whose collector and base are both connected to the emitter of transistor Q24, a transistor Q26 whose collector is connected to the emitter of transistor Q25 and whose base is connected to the base of transistor Q23, a resistor R17 one end of which is connected to the emitter of transistor Q26 and the other of which is connected to ground, a transistor Q27 whose collector is connected to the power supply voltage and whose base is connected to the other end of resistor R5, a transistor Q28 whose collector and base are both connected to the emitter of transistor Q27, a transistor Q29 whose collector is connected to the emitter of transistor Q28 and whose base is connected to the base of transistor Q26, a resistor R18 one end of which is connected to the emitter of transistor Q29 and the other of which is connected to ground.

Multiplying means 50 comprises a resistor R23 one end of which is connected to the power supply voltage, a resistor R24 one end of which is connected to the power supply voltage, a resistor R25 one end of which is connected to the power supply voltage, a transistor Q30 whose collector is connected to the other end of resistor R23 and whose base is connected to the emitter of transistor Q25 of 90° phase shifting means 40, a transistor Q34 whose collector is connected to the other end of resistor R24 and whose base is connected to the emitter of transistor Q25, a transistor Q33 whose collector is connected to the collector of transistor Q30 and whose emitter is connected to the emitter of transistor Q34, a transistor Q31 whose collector is connected to the collector of transistor Q34, whose base is connected to the base of transistor Q33 and whose emitter is connected to the emitter of transistor Q30, a transistor Q32 whose collector is connected to the emitter of transistor Q31 and whose base is connected to the emitter of transistor Q17 of 90° phase shifting means 40, a transistor Q35 whose collector is connected to the emitter of transistor Q33, whose base is connected to the collector of transistor Q23 of 90° phase shifting means 40 and whose emitter is connected to the emitter of transistor Q32, a transistor Q36 whose collector is connected to the emitter of transistor Q35 and whose base is connected to the base of transistor Q29 of 90° phase shifting means 40, a resistor R19 one end of which is connected to the emitter of transistor Q36 and the other end of which is connected to ground, a transistor Q37 whose collector is connected to the power supply voltage and whose base is connected to the other end of resistor R23, a transistor Q38 whose collector is connected to the emitter of transistor Q37 and whose base is connected to the base of transistor Q36, a resistor R20 one end of which is connected to the emitter of transistor Q38 and the other end of which is connected to ground, a transistor Q39 whose collector is connected to the power supply voltage and whose base is connected to the collector of transistor Q34, a transistor Q40 whose collector is connected to the emitter of transistor Q39 and whose base is connected to the base of transistor Q38, a resistor R21 one end of which is connected to the emitter of transistor Q40 and the other end of which is connected to ground, a transistor Q41 whose base and collector are both connected to the other end of resistor R25 and the base of transistor Q40, and a resistor R22 one end of which is connected to the emitter of transistor Q41 and the other end of which is connected to ground.

An operational explanation according to the above constitution is as follows:

FIGs.4A-4E illustrate output waveforms of various points of the circuit shown in FIG.3.

FIG.4A shows a color sub-carrier signal. When a color sub-carrier signal f_{sc} is applied as the input (IN) to the base of transistor Q7, a phase-inverted signal is output through the collector of transistor Q7. The above phase-inverted signal is applied to the base of transistor Q14. Additionally, when the above color sub-carrier signal (IN) is applied to the base of transistor Q11, a signal phase-shifted by 90° is output through the collector of transistor Q11. The above 90° phase-shifted signal is not clipped due to the control of capacitor C1, and is applied to the base of transistor Q27. The DC voltage level of the signal applied to the base of transistor Q14 is shifted (divided down) by transistors Q15, Q16 and Q17 (which function as diodes), and is then applied to the base of transistor Q32. In addition to this, the DC voltage level of the signal applied to the base of transistor Q27 is shifted by transistor Q27 and the transistor Q28 (functioning as a diode), and is then applied to the bases of transistors Q31 and Q33.

FIG.4B shows a signal which is phase-inverted through the emitter of transistor Q17.

FIG.4C shows a 90° phase-shifted signal output through the emitter of transistor Q28. If the signals applied to the bases of transistors Q30 and Q32 have the same phase or state, a "low" is applied to the base of transistor Q37 through the collector of transistor Q30. On the contrary, if the signals applied to the bases of transistors Q30 and Q32 have opposite phases, a "high" is applied to the base of transistor Q37 through the collector of transistor Q30, and thus a "high" is output through the emitter of transistor Q37. Thus, an exclusive OR function is performed on the above input phase-inverted signal and 90° phase-shifted signal.

FIG.4D shows that the phase-inverted signal and the 90° phase-shifted signal are multiplied and then output through the emitter of transistor Q37.

FIG.4E shows a frequency quadrupled signal output when the circuit of FIG.3 is constructed in two layers (i.e. cascaded as circuits 10, 20).

Thus, a quadruple frequency generating circuit is provided internally of the character generating integrated circuit, so as to be used as a clock to generate a blue screen.

Accordingly, a frequency multiplier of the present invention is provided within the character generating integrated circuit, which removes the necessity of an additional quartz-crystal oscillator, to thereby reduce product costs. Further, noise can be reduced because the quartz-crystal oscillator is not used.

## Claims

1. A character generating circuit which generates a clock so as to create a blue screen by serially connecting two frequency doublers (10, 20).

2. A circuit according to Claim 1 in which said frequency doublers comprise:
phase inverting means (30) for inputting and phase-inverting a color sub-carrier signal; and
90° phase shifting means (40) for inputting said color sub-carrier signal and performing 900 phase-shifting thereto.

3. A circuit according to Claim 2, further comprising multiplying means (50) for outputting a doubled signal resulted from an exclusive-OR multiplication of the output of said phase inverting means (30) by the output of said 90° phase shifting means (40) .

4. A frequency multiplier comprising:
phase inverting means (30) for inputting and phase-inverting a video signal;
90° phase shifting means (40) for inputting said video signal and performing 90° phase-shifting thereto; and
means (50) for outputting a doubled signal resulting from a multiplication of the output of said phase inverting means by the output of said 90° phase shifting means.

5. A multiplier accordingly to Claim 4, in which said outputting means are analog multiplying means (50).

6. A multiplier according to Claim 4 or Claim 5 in which said video signal is a colour subcarrier signal.

7. A method of frequency multiplying a color subcarrier video signal by inverting said signal; quadrature phase shifting said signal; and multiplying together the phase shifted and phase-inverted signals.

8. A character generating circuit which generates a clock so as to create a blue screen by serially connecting two frequency doublers both of which comprise:
phase inverting means (30) for inputting and phase-inverting a color sub-carrier signal; and
90° phase shifting means (40) for inputting said color sub-carrier signal and performing 900 phase-shifting thereto; and
analog multiplying means (50) for outputting a doubled signal resulted from an exclusive-OR multiplication of the output of said phase inverting means by the output of said 90° phase shifting means.
